(19) **Europäisches Patentamt / European Patent Office / Office européen des brevets**

(11) **EP 3 084 402 B1**

(12) **FASCICULE DE BREVET EUROPEEN**

(45) Date de publication et mention de la délivrance du brevet:
**08.10.2025 Bulletin 2025/41**

(21) Numéro de dépôt: **14816242.3**

(22) Date de dépôt: **19.12.2014**

(51) Classification Internationale des Brevets (IPC):
**G01N 21/64** *(2006.01)*     **H01L 21/66** *(2006.01)*
**G01N 21/95** *(2006.01)*

(52) Classification Coopérative des Brevets (CPC):
**G01N 21/6489; G01N 21/9501; H01L 22/12;**
**Y02E 10/50**

(86) Numéro de dépôt international:
**PCT/EP2014/078626**

(87) Numéro de publication internationale:
**WO 2015/091895 (25.06.2015 Gazette 2015/25)**

(54) **PROCEDE DE CONTROLE DE QUALITE DE CELLULES PHOTOVOLTAÏQUES**

VERFAHREN ZUR ÜBERWACHUNG DER QUALITÄT VON PHOTOVOLTAIKZELLEN

METHOD FOR MONITORING THE QUALITY OF PHOTOVOLTAIC CELLS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2013 FR 1363105**

(43) Date de publication de la demande:
**26.10.2016 Bulletin 2016/43**

(60) Demande divisionnaire:
**19158799.7 / 3 511 701**

(73) Titulaire: **Commissariat à l'Energie Atomique et aux Energies Alternatives**
**75015 Paris (FR)**

(72) Inventeurs:
• **NOS AGUILA, Oriol**
  **08021 Barcelona (ES)**
• **FAVRE, Wilfried**
  **73000 Chambéry (FR)**
• **OZANNE, Fabien**
  **38580 Allevard (FR)**
• **RIBEYRON, Pierre-Jean**
  **38330 Saint Ismier (FR)**

(74) Mandataire: **Novaimo**
**Europa 1**
**362, avenue Marie Curie**
**Archamps Technopole**
**74166 Saint-Julien-en-Genevois Cedex (FR)**

(56) Documents cités:
**WO-A1-2009/121133     US-A1- 2011 025 839**

• GREGORY BROWN ET AL: "Quantitative measurements of electronic nonuniformities in thin film photovoltaics and their impact on device performance", PHOTOVOLTAIC SPECIALISTS CONFERENCE (PVSC), 2011 37TH IEEE, IEEE, 19 June 2011 (2011-06-19), pages 63 - 68, XP032167591, ISBN: 978-1-4244-9966-3, DOI: 10.1109/PVSC.2011.6185847
• RONNY BAKOWSKIE, RONNY LANTZSCH, THOMAS KADEN, KARL GEORG ELLER, DOMINIK LAUSCH,YVONNE LUDWIG, KAI PETTER: "COMPARISON OF RECOMBINATION ACTIVE DEFECTS IN MULTICRYSTALLINE SILICON BY MEANSOF PHOTOLUMINESCENCE IMAGING AND REVERSE BIASED ELECTROLUMINESCENCE", PROCEEDINGS / 26TH EUROPEAN PHOTOVOLTAIC SOLAR ENERGY CONFERENCE AND EXHIBITION, HAMBURG, GERMANY, CONFERENCE 5 - 9 SEPTEMBER 2011, 13 October 2011 (2011-10-13), XP040637481, ISBN: 978-3-936338-27-0

- **TIAGO FERREIRA ET AL: "ImageJ User Guide IJ 1.46r", 2 October 2012 (2012-10-02), XP055178810, Retrieved from the Internet <URL:http://rsbweb.nih.gov/ij/docs/guide/user-guide.pdf> [retrieved on 20150324]**
- **WU-JA LIN ET AL: "Automatic detection of internal defects in solar cells", 2011 IEEE INTERNATIONAL INSTRUMENTATION AND MEASUREMENT TECHNOLOGY CONFERENCE (I2MTC 2011) : HANGZHOU, CHINA, 10 - 12 MAY 2011, IEEE, PISCATAWAY, NJ, 10 May 2011 (2011-05-10), pages 1 - 4, XP031957573, ISBN: 978-1-4244-7933-7, DOI: 10.1109/IMTC.2011.5944258**

**Description**

La présente invention concerne un procédé de contrôle de qualité de cellules photovoltaïques, par exemple par photoluminescence ou par électroluminescence.

Une image de photoluminescence d'une cellule photovoltaïque, acquise suite à une excitation de la cellule par un faisceau d'éclairement, permet de localiser des défauts préjudiciables à la performance de la cellule. Ces défauts apparaissent dans l'image comme des zones plus obscures que le fond de l'image. Différentes méthodes proposent d'utiliser les images de photoluminescence pour déterminer des paramètres de la cellule, notamment pour identifier et/ou quantifier les défauts présents dans la cellule.

Le document « Calculation of quantitative shunt values using photoluminescence imaging », Augarten Y., Trupke T., Lenio M., Bauer J., Weber J.W., Juhl M. Kasemann M., Breitenstein O. (Prog. Photovolt. : Res. Appli., 21 :933-941. Doi :10.1002/pip.2180 (2013)) propose une méthode de quantification de pertes en courant dues à des défauts présents dans une cellule à partir d'images de photoluminescence de la cellule. Le document « Suns-PLI as a powerful tool for spatially resolved fill factor analysis of solar cells » Mchl B., Impera D., Bivour M., Warta W., Schubert M.C. (Prog. Photovolt. : Res. Appl. Doi 10.1002/pip.2293 (2012)) décrit une méthode de détermination d'une carte de tension en circuit ouvert (VOC) et de carte de pseudo-facteur de forme (PFF) d'une cellule de silicium à partir d'intensités de photoluminescence mesurées pour les pixels d'une image de photoluminescence de la cellule. Le document « Correlations of Cu(In, Ga)Se2 imaging with device performance, defects and microstructural properties » Johnston S. et al. (J. Vac. Sci. Technol. A 30, 04D111 (2012)) étudie la corrélation entre une intensité moyenne de luminescence d'une cellule Cu(InGa) Se2, déterminée à partir d'images de luminescence de la cellule, et, d'une part, une tension en en circuit ouvert de la cellule et, d'autre part, un facteur de forme de la cellule. Le document « Comparison of recombination active defects in multicrystalline silicon by means of photoluminescence imaging and reverse biased electroluminescence ≫, Ronny Bakowskic et al. (26th European Photovoltaic Solar Energy Conference and Exhibition, page 1839 (2011)) étudie les images de photoluminescence et d'électroluminescence à l'aide d'un traitement d'image. Enfin, le document US 2011/0025839 A1 décrit l'analyse d'images de photoluminescence de cellules photovoltaïques à l'aide de différentes méthodes de traitement d'image afin d'établir, par exemple, une corrélation entre la densité de défauts et la tension en circuit ouvert.

L'invention concerne un procédé de contrôle de qualité d'une pluralité de cellules photovoltaïques comprenant, pour chaque cellule :

- une étape d'excitation, lors de laquelle la cellule à contrôler est soumise à une excitation ;
- une étape d'acquisition d'au moins une image de luminescence de la cellule à contrôler après excitation ;
- une étape de traitement de l'image acquise;

caractérisé en ce, pour chaque cellule à contrôler, lors de l'étape de traitement, on décompose l'image de luminescence de la cellule à contrôler en une première image correspondant à ladite cellule sans défauts et une deuxième image correspondant à des défauts de ladite cellule.

De plus, selon l'invention, pour décomposer l'image de luminescence de la cellule à contrôler, l'image de luminescence de ladite cellule étant composée d'un ensemble de pixels auxquels des valeurs respectives d'intensité de luminescence sont attribuées :

- on choisit une pluralité de pixels de ladite image de luminescence :
- on attribue à chacun des pixels choisis une valeur qui est représentative d'un environnement local dudit pixel ;
- on attribue une nouvelle valeur à chaque pixel de l'image à partir des valeurs des pixels choisis afin d'obtenir une première image correspondant à la cellule sans défauts ;
- on détermine une deuxième image correspondant à des défauts de ladite cellule à partir de l'image de luminescence et de la première image en réalisant un ratio entre l'image de luminescence de la cellule et la première image.

Avantageusement, on calcule une moyenne des valeurs d'intensité de luminescence associées aux pixels de la deuxième image afin de déterminer un paramètre de quantification des défauts de la cellule.

Le procédé comprend avantageusement tout ou partie des caractéristiques additionnelles suivantes :

- on attribue une nouvelle valeur à chaque pixel de l'image par interpolation des valeurs des pixels choisis ;
- le paramètre de quantification des défauts est corrigé par un facteur de correction déterminé à partir d'une moyenne de valeurs des pixels de la première image ;
- les pixels choisis de l'image de luminescence sont situés à des emplacements périodiquement espacés.

L'invention sera mieux comprise à l'aide de la description suivante d'un mode de réalisation particulier du procédé de l'invention et du système de contrôle de qualité d'une pluralité de cellules photovoltaïques non revendiqué, en référence aux dessins annexés sur lesquels :

- la figure 1 représente le système de contrôle de qualité, non revendiqué

- la figure 2 représente des données d'évolution de la réponse de luminescence d'une cellule photovoltaïque en fonction d'un niveau d'excitation appliqué, l'intensité étant normalisée pour un niveau d'excitation choisi ;

- la figure 3 représente des données d'évolution de l'intensité de luminescence de cellules photovoltaïques d'apprentissage en fonction des tensions en circuit ouvert de ces cellules ;

- la figure 4A représente une image de luminescence relative à une cellule photovoltaïque à contrôler ;

- les figures 4B et 4C représentent deux images obtenues par décomposition de l'image de la figure 4A ;

- les figures 5A et 5B représentent des étapes d'une phase d'apprentissage du procédé, selon un mode de réalisation particulier ;

- les figures 6A et 6B représentent des étapes d'une phase de contrôle de qualité du procédé selon un mode de réalisation particulier ;

- la figure 7 représente les caractéristiques courant-tension et puissance-tension d'une cellule photovoltaïque ;

- la figure 8 représente des données de corrélation entre une paramètre de perte de facteur de forme et un paramètre de quantification des défauts d'une cellule.

Le procédé concernant la détermination du niveau d'excitation ainsi que l'apprentissage et le système associés ne font pas partie de l'invention revendiquée. Le procédé de contrôle de qualité de l'invention permet de contrôler la qualité de cellules photovoltaïques fabriquées sur une ligne de production L, afin le cas échéant de détecter une ou plusieurs cellules ayant des performances insuffisantes par rapport aux performances souhaitées.

Le contrôle de qualité peut être est mis en œuvre par un système comportant :

- un dispositif d'excitation 1, destiné à exciter une cellule photovoltaïque de façon à ce qu'elle émette des photons par luminescence,
- un dispositif 2 d'acquisition d'images de luminescence, tel qu'une caméra, destiné à acquérir des images numériques représentatives des photons émis par une cellule photovoltaïque en réponse à une excitation, autrement dit des images de la réponse de luminescence de la cellule suite à une excitation,
- un capteur 3 de mesure d'intensité de luminescence, adapté pour mesurer l'intensité de luminescence d'un signal de photons émis par une cellule photovoltaïque après excitation,
- un dispositif de contrôle 4.

Le système de contrôle de qualité, non revendiqué, comprend des moyens matériels et logiciels pour mettre en œuvre les étapes du procédé décrit plus loin.

Le dispositif de contrôle 4 comprend notamment une unité centrale (non représentée), en l'espèce un microprocesseur, et différents modules logiciels :

- un module d'apprentissage 40, apte à commander l'exécution des étapes d'une phase d'apprentissage,
- un module 41 de détermination d'un niveau d'excitation ajusté pour une cellule photovoltaïque,
- un module 42 de traitement d'image et de détermination d'un paramètre de quantification de défauts d'une cellule photovoltaïque,
- un module 43 d'évaluation d'un paramètre de perte de facteur de forme,
- un module 44 de sélection de cellule.

Le dispositif de contrôle 4 comprend en outre une mémoire de stockage 45, pour mémoriser notamment des données obtenues lors de la phase d'apprentissage, et une interface homme-machine 46 (écran, clavier, etc.).

Dans l'exemple de réalisation décrit ici, le mode d'excitation des cellules photovoltaïques est un faisceau lumineux laser. Le dispositif d'excitation 1 est une source d'émission laser. En variante, on pourrait utiliser un autre type de faisceau lumineux ou une excitation par courant électrique.

Les cellules photovoltaïques sont par exemple des cellules silicium à hétérojonction, ou cellules solaires SHJ (de l'anglais « Silicon HeteroJunction »). On pourrait toutefois envisager d'appliquer le système et le procédé à tout autre type de cellules photovoltaïques. On pourra citer par exemple les cellules silicium homojonction, les cellules couches minces à base de silicium amorphe ou d'autres semi-conducteurs tels que les cellules CdTe (Tellure de Cadmium), le CuInGaSe (Cuivre-Indium-Sélénite de Gallium) ou le GaAs (Arsénite de Gallium ) ou encore les cellules multijonctions.

Le procédé comprend une phase initiale d'apprentissage de la ligne de production L, décrite ci-après.

Phase d'apprentissage :

La phase d'apprentissage permet de déterminer différents paramètres relatifs aux cellules photovoltaïques produites par la ligne de production L, à savoir :

- des données d'évolution de l'intensité de luminescence de cellules photovoltaïques produites par la ligne de production L en fonction d'une tension en circuit ouvert (courbe $C_1$) ;
- une valeur de référence, ou cible, d'intensité de luminescence, notée $I_{PL,ref}$, pour des cellules photovoltaïques à contrôler ;
- des données d'évolution de la réponse de luminescence d'une cellule photovoltaïque en fonction du niveau d'excitation appliqué à celle-ci (courbe $C_2$) ;
- des données de corrélation entre un paramètre GL de quantification de défauts d'une cellule photovoltaïque et un paramètre de perte de facteur de forme de cette cellule ;
- un seuil $TSH_{GL}$ de paramètre de quantification de défauts.

La phase d'apprentissage comprend une première étape E00 de fabrication d'un lot de N cellules photovoltaïques dites « d'apprentissage », notées $CLA_1$, $CLA_2$, ..., $CLA_i$, ..., $CLA_N$, par la ligne de production L. Par exemple, le nombre N peut être de l'ordre de quelques centaines voire de quelques milliers de cellules, suivant le degré de précision que l'on cherche (échantillon représentatif).

Les étapes E01 à E06 permettent de déterminer la courbe $C_1$ et l'intensité de luminescence de référence $I_{PL,ref}$.

De façon connue, une cellule photovoltaïque est caractérisée par une tension en circuit ouvert « $V_{oc}$ », correspondant à la tension aux bornes de la cellule quand aucun courant I n'est débité (I=0). Une ligne de production produit généralement des cellules dont les tensions $V_{oc}$ respectives peuvent varier légèrement d'une cellule à l'autre. Typiquement, les tensions $V_{oc}$ d'un lot de cellules photovoltaïques produites par une ligne de production sont réparties selon une distribution gaussienne autour d'une valeur moyenne $V_{oc}$ et avec un écart type σ donné.

Lors de l'étape E01, on mesure la tension en circuit ouvert $V_{oc\_i}$ de chacune des cellules d'apprentissage $CLA_i$, de façon connue.

Lors de l'étape E02, on calcule une valeur moyenne $\overline{V_{oc}}$ de tension en circuit ouvert, à partir des tensions $V_{oc\_i}$ mesurées pour les cellules $CLA_1$ à $CLA_N$.

On mesure ensuite les réponses de photoluminescence de chacune des cellules d'apprentissage $CLA_1$ à $CLA_N$, lorsque celles-ci sont soumises à un faisceau laser d'excitation, avec un niveau d'éclairement choisi, à l'aide du dispositif d'émission laser 1. Dans l'exemple décrit ici, on choisit un niveau d'éclairement égal à 40% de la puissance maximale d'émission laser du dispositif d'émission laser 1, la densité de puissance maximale du laser étant de l'ordre de 120 mW/cm$^2$, et une durée d'émission du faisceau laser de l'ordre de 10 ms. On pourrait choisir un niveau d'éclairement différent, en toute hypothèse adapté de manière à ce que les réponses de photoluminescence des cellules photovoltaïques ne saturent pas le dispositif d'acquisition 2. Notons $P_{init}$ ce niveau d'éclairement initial choisi. En variante, pour obtenir le niveau d'éclairement souhaité, on pourrait choisir une densité de puissance laser fixe (par exemple 40% de la puissance maximale) et régler le niveau d'éclairement en variant la durée du temps d'excitation de la cellule, c'est-à-dire, la durée d'émission du faisceau laser.

Pour mesurer les réponses de photoluminescence des cellules au niveau d'éclairement initial choisi $P_{init}$, lors de l'étape E03, on soumet chaque cellule d'apprentissage $CLA_i$, avec l'indice i étant initialement égal à 1, à un faisceau laser, le dispositif laser 1 étant réglé à une puissance choisie de 40% de sa puissance maximale d'émission.

Lors de l'étape E04, on mesure l'intensité de photoluminescence $I_{PL\_i}$ du signal émis par la cellule d'apprentissage $CLA_i$ en réponse à l'excitation laser appliquée lors de l'étape E03.

Pour un niveau d'éclairement donné, il est connu que l'intensité de photoluminescence $I_{PL}$ d'une cellule photovoltaïque dépend de la tension en circuit ouvert $V_{oc}$ de cette cellule. Plus précisément, l'intensité $I_{PL}$ est proportionnelle à $\left(\frac{eV_{oc}}{kT}\right)$. Autrement dit, on a la relation suivante :

$$I_{PL} \propto exp\left(\frac{eV_{oc}}{kT}\right) \qquad\qquad (1)$$

où :

- e représente la charge élémentaire ;
- k représente la constante de Boltzmann et
- T représente la température.

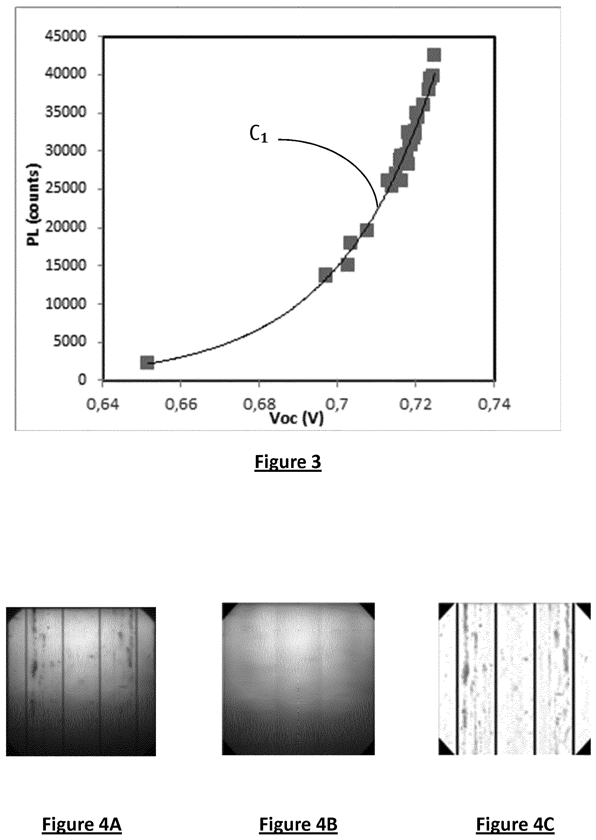

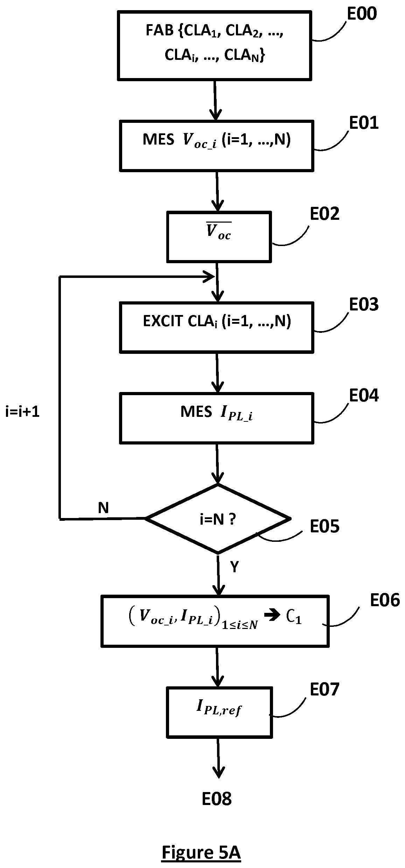

Les étapes E03 et E04 sont réitérées pour chacune des cellules d'apprentissage CLA$_i$, l'indice i allant de 1 à N. Une étape de test E05 est prévue pour que le procédé revienne à l'étape E03 tant que l'indice i est inférieur à N (branche N sur la figure 4). Lorsque les réponses de photoluminescence de toutes les cellules CLAi, avec i allant de 1 à N, ont été mesurées, le procédé passe à l'étape E06 (branche Y sur la figure 5A).

A l'issue de l'étape E05, on dispose, pour chaque cellule d'apprentissage CLA$_i$ (avec i compris entre 1 et N), d'un couple de valeurs mesurées ($V_{oc\_i}$, $I_{PL\_i}$) contenant chacun la tension en circuit ouvert mesurée $V_{oc\_i}$ et l'intensité de photoluminescence $I_{PL\_i}$ de la cellule CLA$_i$, mesurée en réponse à un éclairement choisi égal à 40% de la puissance maximale d'émission laser du dispositif 1.

Lors de l'étape E06, à partir des couples ($V_{oc\_i}$, $I_{PL\_i}$) et compte tenu de la relation de proportionnalité (1) connue, le dispositif de contrôle 4 détermine des premières données d'évolution de l'intensité de photoluminescence $I_{PL}$ en fonction de la tension en circuit ouvert $V_{oc}$ pour les cellules d'apprentissage. Ces premières données d'évolution forment la courbe C$_1$ telle que représentée sur la figure 3. Cette courbe C$_1$ est ainsi déterminée à partir de données d'apprentissage constituées par les couples ($V_{oc\_i}$, $I_{PL\_i}$) et de la relation (1).

Lors d'une étape E07, le dispositif de contrôle 4 détermine la valeur de référence de l'intensité de photoluminescence $I_{PL,ref}$ à partir d'une valeur de tension en circuit ouvert de référence $V_{oc,ref}$ et à l'aide de la courbe C$_1$. Dans l'exemple de réalisation décrit ici, la tension en circuit ouvert de référence $V_{oc,ref}$ est choisie égale à la valeur moyenne de tension en circuit ouvert $\overline{V_{oc}}$. L'intensité de référence $I_{PL,ref}$ est donc égale à l'intensité de photoluminescence associée (ou couplée) à la tension de référence $V_{oc,ref}$, ici égale à $\overline{V_{oc}}$, sur la courbe C$_1$. En variante, la tension de référence $V_{oc,ref}$ pourrait être l'une quelconque des valeurs de tension $V_{oc}$ comprises entre la moyenne $\overline{V_{oc}}$ augmentée de deux fois l'écart type $\sigma$ et la moyenne $\overline{V_{oc}}$ diminuée de deux fois l'écart type $\sigma$, c'est-à-dire comprise dans l'intervalle [$\overline{V_{oc}}$ - 2$\sigma$; $\overline{V_{oc}}$ + 2$\sigma$].

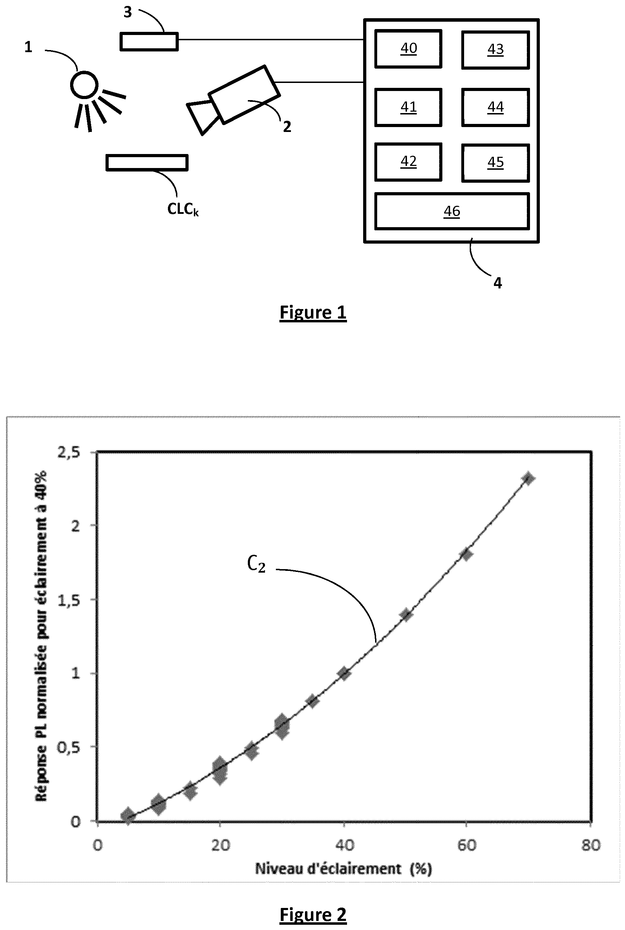

Le procédé passe ensuite aux étapes E08 à E011 permettant la détermination de deuxièmes données d'évolution relatives à la réponse de photoluminescence d'une cellule photovoltaïque produite par la ligne de production L en fonction du niveau d'éclairement appliqué à cette cellule. Par « réponse de photoluminescence », on entend ici désigner l'intensité de photoluminescence du signal de photons émis par la cellule en réponse à une excitation. Ces deuxièmes données d'évolution forment une deuxième courbe notée C$_2$ telle que représentée sur la figure 2. Notons que la courbe d'évolution C$_2$ peut être déterminée à partir d'une seule cellule d'apprentissage, voire de quelques cellules d'apprentissage. En effet, l'évolution de la réponse de photoluminescence d'une cellule produite par la ligne L en fonction du niveau d'éclairement est analogue, ou sensiblement analogue, d'une cellule à l'autre, quelle que soit notamment la tension en circuit ouvert de la cellule. Dans l'exemple de réalisation particulier décrit ici, les étapes E08 à E11 sont ici mises en œuvre pour une cellule d'apprentissage, par exemple la cellule CLA$_1$. En variante, on pourrait réitérer ces étapes E08 à E011 pour un nombre limité de cellules d'apprentissage.

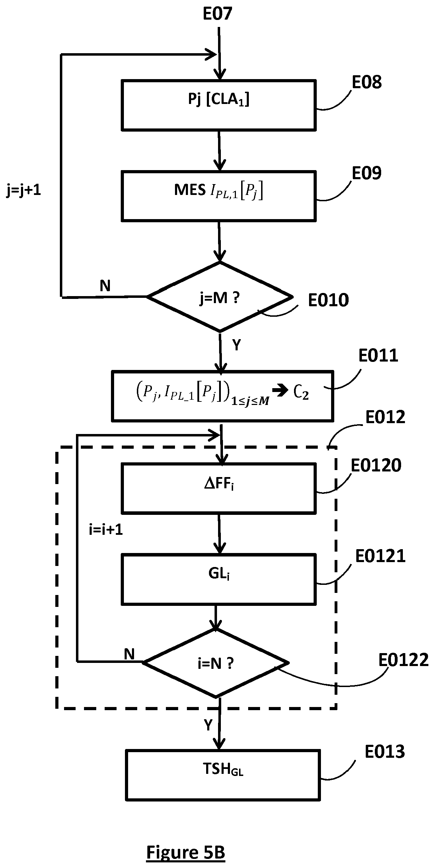

En référence à la figure 5B , lors de l'étape E08, on soumet la cellule CLA1 à un niveau de puissance laser P$_j$, l'indice j étant initialement égal à 1. Par exemple, le premier niveau de puissance laser appliqué P$_1$ correspond à 10% de la puissance laser maximale d'émission du dispositif laser 1.

Lors d'une étape E09, on mesure la réponse de photoluminescence de la cellule CLA$_1$, c'est-à-dire l'intensité de luminescence du signal de photons émis par celle-ci, notée $I_{PL\_1}[P_j]$, en réponse à l'excitation laser de puissance P$_j$.

Les étapes E08 et E09 sont réitérées pour une pluralité de niveaux de puissance laser P$_j$, avec j=1, 2, 3, ..., M, allant par exemple de 10% à environ 80% de la puissance laser maximale du laser 1. On effectue par exemple une dizaine de mesures d'intensité de luminescence $I_{PL\_1}[P_j]$ pour un nombre correspondant de niveaux de puissance laser différents.

Une étape de test E010 est prévue pour que le procédé revienne à l'étape E08 tant que l'indice j est inférieur à M (branche N sur la figure 5B). Lorsque la réponse de photoluminescence de la cellule CLA$_1$ a été mesurée pour les M niveaux d'éclairement P$_j$, avec j=1, 2, 3, ..., M, le procédé passe à l'étape E011 (branche Y sur la figure 5B).

A l'issue de l'étape E010, une fois que les étapes E08 et E09 ont été réitérés M fois, on obtient M couples de valeurs ($P_j$, $I_{PL\_1}[P_j]$), avec j=1, 2, 3, ..., M.

Lors de l'étape E011, à partir des M couples de valeurs ($P_j$, $I_{PL\_1}[P_j]$), le dispositif de contrôle 4 détermine des deuxièmes données d'évolution de l'intensité de photoluminescence d'une cellule photovoltaïque produite par la ligne de fabrication L en fonction du niveau d'éclairement. Ces deuxièmes données d'évolution formant la courbe C$_2$, telle que représentée sur la figure 2. Cette courbe C$_2$ est la même, ou sensiblement la même, pour toutes les cellules produites par la ligne de production L, quelles que soient leurs valeurs de $V_{oc}$ respectives. Dans le cas représenté sur la figure 2, la courbe C2 peut être ajustée par une loi polynomiale du type

$$\frac{I_{PL\_1}[P_j]}{I_{PL\_1}[P=40\%]} = a + b \cdot P_j + c \cdot P_j^2 + \cdots$$

La phase d'apprentissage permet ainsi de déterminer les courbes d'évolution C$_1$ et C$_2$, basées sur des données d'apprentissage (c'est-à-dire des données de mesure relatives aux cellules d'apprentissage) et peut être réalisée à la première mise en service de la ligne de production L.

La phase d'apprentissage comprend également des étapes E012 et E013 permettant de déterminer un seuil critique de paramètre de quantification de défauts TSH$_{GL}$. Ces étapes E012 et E013 seront décrites plus loin.

Contrôle de qualité

On va maintenant décrire la phase de contrôle de qualité de cellules photovoltaïques produites par la ligne de production L, mise en œuvre après la phase d'apprentissage. Notons CLC$_k$, avec k= 1, 2, ..., un ensemble de cellules photovoltaïques à contrôler.

Dans le mode de réalisation particulier décrit ici, le contrôle de qualité est mis en œuvre pour chaque cellule à contrôler CLC$_k$, avant la fin du processus de fabrication de la cellule, et plus précisément avant métallisation de celle-ci.

Le contrôle de qualité comprend, pour chaque cellule à contrôler CLC$_k$ :

- une étape préalable E2 de détermination d'un niveau d'excitation ajusté à la cellule à contrôler CLC$_k$ ;
- une étape d'excitation E3, lors de laquelle ladite cellule CLC$_k$ est soumise à une excitation à un niveau d'excitation ajusté ;
- une étape E4 d'acquisition d'au moins une image de luminescence de la cellule CLC$_k$ après excitation ;
- une étape E5 de traitement de l'image acquise.

Ajustement du niveau d'excitation :

L'étape préalable E2 consiste à déterminer un niveau d'excitation, en l'espèce un niveau d'éclairement, ajusté à ladite cellule CLC$_k$. Par définition, un niveau d'excitation « ajusté » à une cellule photovoltaïque est un niveau d'excitation adapté de manière à ce que l'intensité de luminescence $I_{PL,k}$ du signal de photons émis par la cellule considérée, en réponse au niveau d'excitation appliqué, soit égale à l'intensité de référence $I_{PL,ref}$. Notons $P[CLC_k]$ le niveau d'excitation ajusté à la cellule CLC$_k$, correspondant ici à un niveau d'éclairement défini par un pourcentage de la puissance maximale d'émission du dispositif d'émission laser 1.

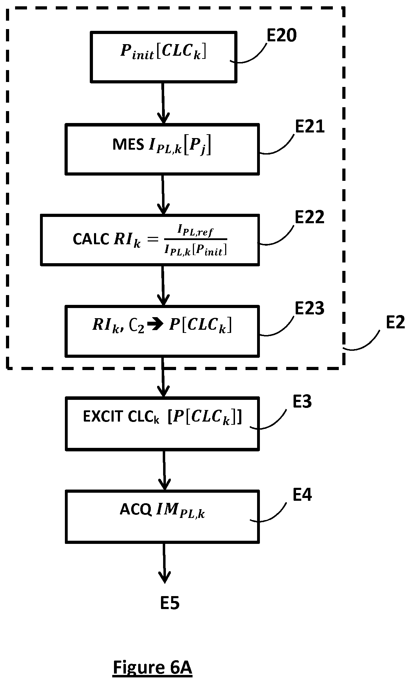

L'étape E2 comprend les sous-étapes E20 à E23 décrites ci-après, en référence à la figure 6A.

La sous-étape E20 consiste à soumettre la cellule à contrôler CLC$_k$ à un niveau d'excitation initial choisi $P_{init}$ à l'aide du dispositif d'émission laser 1. Le niveau d'excitation initial $P_{init}$ correspond à un niveau d'éclairement ici égal à 40% de la puissance laser maximale d'émission du dispositif laser 1.

Le capteur 2 mesure l'intensité de photoluminescence $I_{PL,k}[P_{init}]$ du signal de photons émis par la cellule CLC$_k$ en réponse à l'excitation $P_{init}$, lors de la sous-étape E21.

Lors de la sous-étape E22, le dispositif de contrôle 4 calcule un rapport d'intensités entre la valeur de référence d'intensité de luminescence et la valeur mesurée d'intensité de luminescence, c'est-à-dire entre $I_{PL,ref}$ et $I_{PL,k}[P_{init}]$. Notons $RI_k$ ce rapport d'intensités :

$$RI_k = \frac{I_{PL,ref}}{I_{PL,k}[P_{init}]}$$

Lors d'une étape E23, le dispositif de contrôle 4 détermine le niveau d'excitation $P[CLC_k]$ ajusté à la cellule CLC$_k$ à partir du rapport d'intensités $RI_k$ et à l'aide de la courbe C$_2$.

A ce rapport d'intensités $RI_k$ correspond un rapport de niveaux d'éclairement constituant un facteur d'ajustement $\alpha_k$ à appliquer au niveau d'excitation initial $P_{init}$ pour obtenir le niveau d'excitation $P[CLC_k]$ ajusté à la cellule CLC$_k$.

Dans le mode de réalisation particulier décrit ici, la courbe C$_2$ est normalisée pour le niveau d'éclairement initial choisi $P_{init}$. Cela signifie que la réponse de photoluminescence au niveau d'éclairement défini par $P_{init}$ (ici 40%) est ramenée à 1 et que l'ensemble des points de la courbe C$_2$ est adapté de façon analogue. Grâce à cela, le niveau d'éclairement ajusté $P[CLC_k]$ est donné directement par la courbe C$_2$ à partir du rapport $RI_k$ pris en tant que réponse de photoluminescence. En d'autres termes, le niveau d'éclairement ajusté à la cellule CLC$_k$ est le niveau d'éclairement associé sur la courbe C$_2$ à la réponse de photoluminescence égale au rapport d'intensités $RI_k$.

Prenons l'exemple d'une cellule à contrôler, par exemple CLC$_1$, à laquelle on applique un niveau d'éclairement initial choisi $P_{init}$ égal à 40% de la puissance maximale du dispositif d'émission laser 1. En référence à la figure 2, l'intensité de photoluminescence $I_{PL,1}[P_{init}]$ du signal de photons émis par la cellule CLC$_1$ en réponse à l'éclairement à $P_{init}$ (40%) est de l'ordre de 40000 photons. L'intensité de référence $I_{PL,ref}$ étant égale à 20000 photons sur la figure 2, le rapport d'intensités $RI_1$ vaut 0,5. Sur la courbe C$_2$, la valeur normalisée de réponse de photoluminescence de 0,5 (RI$_1$) correspond

à un niveau d'éclairement de 25% de la puissance laser maximale. On détermine ainsi que le niveau d'éclairement ajusté à la cellule $CLC_1$ est égal à 25% de la puissance laser maximale.

Excitation

Lors de l'étape d'excitation E3, la cellule à contrôler $CLC_k$ est soumise à une excitation au niveau d'excitation ajusté déterminé lors de l'étape E2. Dans l'exemple particulier décrit ici, la cellule à contrôler $CLC_k$ est ainsi soumise à un éclairement ajusté dont le niveau est défini par la puissance $P[CLC_k]$ préalablement déterminé à l'étape E2.

Acquisition

Lors de l'étape E4, le dispositif d'acquisition 2 prend une image, notée $IM_{PL,k}$, de photoluminescence de la réponse de photoluminescence de la cellule $CLC_k$ suite à l'excitation au niveau d'éclairement $P[CLC_k]$. L'image de photoluminescence $IM_{PL,k}$ de ladite cellule à contrôler $CLC_k$ est composée d'un ensemble de pixels $p_i$ associés à des valeurs respectives d'intensité de luminescence, notées $IM_{PL,k,i}$, i représentant ici un indice de pixel. Autrement dit, une intensité de luminescence $IM_{PL,k,i}$ est attribuée à chaque pixel d'image $p_i$. Notons n le nombre total de pixels $p_i$ d'une image de photoluminescence acquise.

Traitement d'image

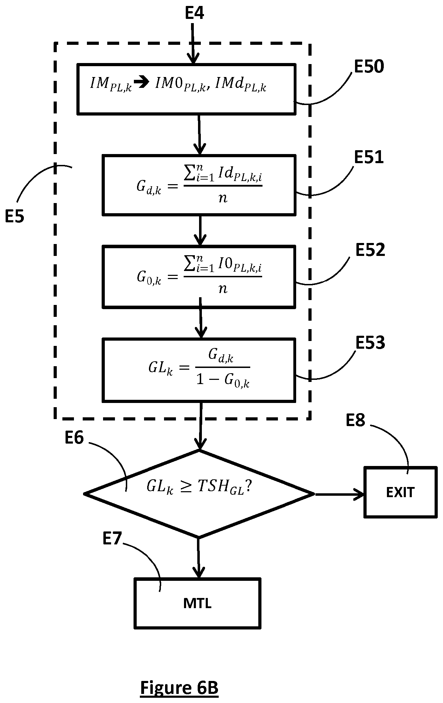

Le dispositif de contrôle 4 met ensuite en œuvre une étape de traitement d'image E5 comportant les sous-étapes E50 à E53, décrites ci-après en référence à la figure 6B. Le traitement d'image E5 permet de déterminer un paramètre $GL_k$ de quantification des défauts de la cellule à contrôler $CLC_k$, à partir de l'image de photoluminescence $IM_{PL,k}$.

Lors de la sous-étape E50, le dispositif de contrôle 4 décompose l'image de luminescence $IM_{PL,k}$ de la cellule à contrôler CLCk en une première image $IM0_{PL,k}$ correspondant à ladite cellule sans défauts et une deuxième image $IMd_{PL,k}$ correspondant à des défauts de ladite cellule. Ainsi, on découple la réponse de photoluminescence de la cellule $CLC_k$ des effets dérivés de la présence de défauts dans la cellule. L'image $IM0_{PL,k}$ représente le fond de l'image d'origine $IM_{PL,k}$ et correspond à la réponse de photoluminescence de la cellule $CLC_k$ sans défauts.

Pour obtenir la première image $IM0_{PL,k}$, on peut par exemple décomposer l'image originale $IM_{PL,k}$ en choisissant N pixels de cette image originale. Ces N pixels peuvent avantageusement être situés à des emplacements périodiquement espacés. Ils forment une matrice de pixels.

On attribue ensuite à chacun de ces N pixels une valeur qui est représentative de son environnement local direct. L'environnement local d'un pixel donné est défini par une zone spatiale contenant ce pixel, par exemple une zone carrée dont le centre est le pixel choisi. La taille de cette zone d'environnement local est adaptée pour être plus grande que les défauts courants susceptibles de concerner la cellule, qui sont généralement bien connus.

La valeur attribuée à chacun des N pixels choisis est la valeur de pixel la plus élevée de la zone entourant ce pixel et constituant son environnement local.

Ensuite, on attribue une nouvelle valeur à chaque pixel de l'image à partir des valeurs attribuées aux N pixels choisis afin d'obtenir une première image correspondant à la cellule sans défauts. Avantageusement, les nouvelles valeurs des pixels d'image sont déterminées par interpolation des valeurs attribuées aux N pixels choisis. Autrement dit, par calcul d'interpolation, on réattribue une nouvelle valeur à chaque pixel de l'image, hormis aux N pixels initialement choisis (qui ont la valeur la plus élevée de leur environnement). On obtient ainsi la première image $IM0_{PL,k}$ correspondant à ladite cellule sans défauts.

Au lieu d'attribuer à chacun des N pixels choisis la valeur de pixel la plus élevée de son environnement local, on pourrait lui attribuer une autre valeur représentative de son environnement local, par exemple une moyenne des valeurs des pixels de cet environnement local.

Ensuite, on détermine la deuxième image $IMd_{PL,k}$ correspondant à des défauts de ladite cellule à partir de l'image de luminescence (ou image originale) $IM_{PL,k}$ et de la première image $IM0_{PL,k}$. La deuxième image $IMd_{PL,k}$ des défauts de la cellule est obtenu en réalisant un ratio entre l'image d'origine $IM_{PL,k}$ et l'image sans défauts $IM0_{PL,k}$.

Cette méthode permet de reconstruire l'image en éliminant les zones où la réponse de photoluminescence est faible, c'est-à-dire des zones considérées comme des défauts, de manière à obtenir la première image $IM0_{PL,k}$ correspondant à l'image de la cellule sans défauts.

Chaque image ($IM_{PL,k}$, $IM0_{PL,k}$, $IMd_{PL,k}$) contient n pixels d'indice respectifs i et affectés de valeurs respectives d'intensité de luminescence ($I_{PL,k,i}$, $I0_{PL,k,i}$, $Id_{PL,k,i}$).

Lors de la sous-étape E51, le dispositif de contrôle 4 calcule une valeur moyenne des intensités de luminescence attribuées aux pixels de l'image des défauts $IMd_{PL,k}$, à l'aide de l'équation suivante :

$$G_{d,k} = \frac{\sum_{i=1}^{n} Id_{PL,k,i}}{n} \qquad (2)$$

où

- $Id_{PL,k,i}$ représente l'intensité de photoluminescence associée à un pixel d'indice i de l'image $IMd_{PL,k}$ ;
- n représente le nombre total de pixels dans l'image considérée.

Le résultat $G_{d,k}$ de l'équation (2) constitue un premier paramètre de quantification des défauts de la cellule à contrôler CLC$_k$.

Lors de la sous-étape E52, le dispositif de contrôle 4 calcule une valeur moyenne des intensités de luminescence associées aux pixels de l'image sans défaut $IM0_{PL,k}$, à l'aide de l'équation suivante :

$$G_{0,k} = \frac{\sum_{i=1}^{n} I0_{PL,k,i}}{n} \qquad (3)$$

où

- $I0_{PL,k,i}$ représente l'intensité de photoluminescence associée à un pixel d'indice i de l'image $IM0_{PL,k}$ ;
- n représente le nombre total de pixels dans l'image considérée.

Lors de la sous-étape E53, le dispositif de contrôle 4 corrige le premier paramètre de quantification des défauts $G_{d,k}$ à l'aide de la moyenne $G_{0,k}$ selon l'équation suivante :

$$GL_k = \frac{G_{d,k}}{1-G_{0,k}} \qquad (4)$$

Le résultat de cette équation $GL_k$ constitue le paramètre corrigé de quantification des défauts de la cellule CLC$_k$.

La pondération du paramètre $G_{d,k}$ par l'élément $\left(\frac{1}{1-G_{0,k}}\right)$ permet de corriger d'éventuelles déviations causées par des imprécisions dans les niveaux d'éclairement ajustés appliqués aux différentes cellules. Idéalement, le paramètre $G_{0,k}$ est le même pour toutes les cellules à contrôler, dans la mesure où les niveaux d'éclairement ont été réglés, ou ajustés, pour que les intensités de photoluminescence soient toutes identiques (égales à l'intensité de luminescence de référence $I_{PL,ref}$ ). Toutefois, en pratique, l'intensité de luminescence $I_{PL,k}$ émise par une cellule à contrôler CLC$_k$ en réponse à un niveau d'éclairement ajusté peut légèrement dévier par rapport à l'intensité de luminescence de référence $I_{PL,ref}$ visée, en raison par exemple d'une légère erreur de réglage du dispositif d'émission laser 1. Il en résulte soit une surestimation, soit une sous-estimation du paramètre $G_{d,k}$ de quantification des défauts, respectivement dans le cas où $I_{PL,k}$ est supérieure ou inférieure à $I_{PL,ref}$. L'élément $\left(\frac{1}{1-G_{0,k}}\right)$ constitue un facteur de correction du paramètre $G_{d,k}$, qui permet de compenser les éventuelles déviations de l'intensité de luminescence de la cellule à contrôler CLC$_k$.

Corrélation entre paramètres GL et $\Delta$FF

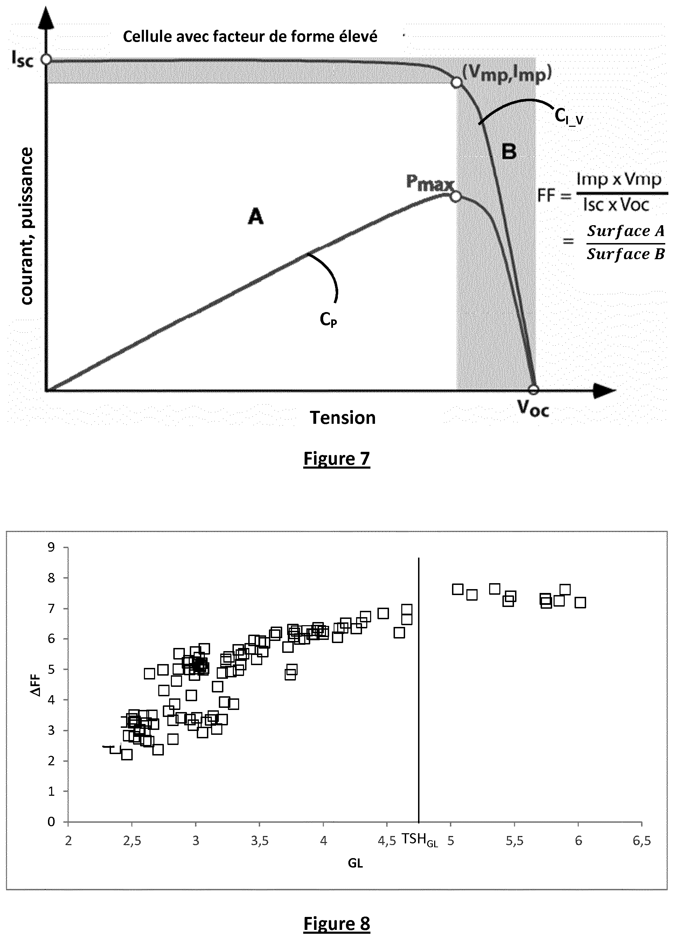

Sur la figure 7, on a représenté les caractéristiques courant-tension (courbe $C_{I\_V}$) et puissance-tension (courbe $C_P$) d'une cellule photovoltaïque. Sur cette figure 7 :

- « $I_{SC}$ » représente le courant en court-circuit de la cellule, c'est-à-dire le courant débité par la cellule lorsque la tension à ses bornes est nulle (V=0) ;
- « $V_{OC}$ » représente la tension en circuit ouvert de la cellule, c'est-à-dire la tension aux bornes de la cellule lorsque le courant débité est nul (I=0) ;
- « $I_{mp}$ » et « $V_{mp}$ » représentent respectivement le courant et la tension d'un point de fonctionnement de la cellule pour lequel la puissance fournie par celle-ci est maximale.

Par définition, le facteur de forme d'une cellule photovoltaïque est égal à

$$FF = \frac{V_{mp}.I_{mp}}{V_{OC}.I_{SC}}$$

Le facteur de forme FF est le rapport entre la puissance maximale fournie par la cellule et la puissance idéale qu'elle fournirait si elle était parfaite, sans défaut. Ce facteur FF représente en définitive le degré d'idéalité de la cellule et constitue un paramètre indicatif des performances de la cellule. Certains défauts (par exemple des impuretés chimiques, des microfractures, des dislocations, etc.) sont susceptibles d'apparaître dans la cellule lors de sa fabrication et de faire diminuer le facteur de forme FF. Notons $\Delta$FF, un paramètre de perte de facteur de forme, représentant une amplitude de diminution du facteur de forme.

Comme précédemment indiqué, la phase d'apprentissage du procédé comprend une étape E012 de détermination d'une corrélation entre les paramètres de quantification des défauts $GL_i$ et le paramètre de perte de facteur de forme $\Delta FF_i$, pour les cellules d'apprentissage $CLA_i$ (i allant de 1 à N). Cette étape E012 comprend, pour chaque cellule d'apprentissage $CLA_i$ :

- une première sous-étape E0120 consistant à mesurer une perte de facteur de forme, soit $\Delta FF_i$, pour la cellule $CLA_i$ ;
- une deuxième sous-étape E0121 consistant à calculer le paramètre $GL_i$ pour la cellule d'apprentissage $CLA_i$.

Les étapes E0120 et E0121 sont réitérées pour chacune des cellules d'apprentissage (test E0122).

Lors de l'étape E0120, la perte de facteur de forme $\Delta FF_i$ est évaluée pour une cellule d'apprentissage finie, après métallisation. Par exemple, la perte de facteur de forme $\Delta FF_i$ peut être définie comme une différence entre le facteur de forme réel mesuré pour la cellule $CLA_i$ et un facteur de forme de référence et pour la cellule $CLA_i$. En variante, on pourrait utiliser une méthode plus précise de quantification de $\Delta FF_i$ prenant en compte différents phénomènes physiques qui impactent le facteur de forme (résistance série, résistance shunt, recombinaisons, ...), telle que celle décrite dans l'article « A Fill Factor Loss Analysis Method for Silicon Wafer Solar Cells » IEEE Journal of photovoltaics, vol.3, N°4, october 2013, Digital Objet Identifier 10.1109/JPHOTOV.2013.2270348.

La sous-étape E0121 consiste à mettre en œuvre l'étape E5 de calcul du paramètre de quantification des défauts $GL_i$ pour la cellule d'apprentissage $CLA_i$, après avoir réalisé les étapes E2 à E4 consistant à déterminer le niveau d'éclairement ajusté à la cellule $CLA_i$, à exciter la cellule $CLA_i$ avec le niveau d'éclairement initial choisi $P_{init}$ et à acquérir une image de photoluminescence de la cellule $CLA_i$ en réponse à l'éclairement ajusté.

A l'issue de l'étape E012, le dispositif 4 mémorise des données d'évolution du paramètre de perte de facteur de forme $\Delta$FF en fonction du paramètre de quantification des défauts GL, comme représenté sur la figure 8.

Lors d'une étape E013, le dispositif 4 détermine un seuil critique de paramètre de quantification des défauts, noté $TSH_{GL}$, au-delà duquel les pertes de facteur de forme sont estimées trop importantes pour que les performances de la cellule soient satisfaisantes. Par exemple, en référence à la figure 8, ce seuil $TSH_{GL}$ est fixé à 4,75. Bien entendu, ce seuil pourrait être différent avec une autre ligne de production de cellules.

Sélection des cellules contrôlées $CLC_k$

La phase de contrôle de qualité de chaque cellule à contrôler $CLC_k$ comprend, suite à l'étape de détermination du paramètre $GL_k$ de la cellule (étape E5), une étape de test E6 consistant à déterminer si les performances de la cellule $CLC_k$ sont satisfaisantes. Le test E6 consiste à déterminer si le paramètre de quantification des défauts $GL_k$ est supérieur ou égal au seuil critique $TSH_{GL}$.

Si le test est négatif, la qualité de la cellule $CLC_k$ est jugée satisfaisante et la cellule $CLC_k$ peut passer à une étape suivante de son processus de fabrication, en l'espèce à une étape de métallisation E7.

Si le test est positif, les performances de la cellule $CLC_k$ sont considérées comme insuffisantes et la cellule $CLC_k$ est retirée de la ligne de production L (étape E8).

Dans l'exemple de réalisation qui vient d'être décrit ici, le procédé de contrôle de qualité est mis en œuvre avant l'étape de métallisation de la cellule mise en œuvre en fin de fabrication. Grâce à cela, les cellules défectueuses peuvent être retirées de la ligne de production avant métallisation, ce qui permet d'économiser du métal. On pourrait toutefois envisager de mettre en œuvre le procédé de contrôle de qualité à la fin de la fabrication des cellules.

Les différentes étapes du procédé sont mises en œuvre par ou sous le contrôle des modules correspondants du dispositif de contrôle 4, notamment :

- le module d'apprentissage 40 est apte à mettre en œuvre les étapes de la phase d'apprentissage ;
- le module 41 de détermination d'excitation est apte à mettre en œuvre l'étape E2 de détermination d'un niveau d'excitation ;
- le module 42 de traitement d'image est apte à mettre en œuvre l'étape E5 de traitement d'image. ;

- la module 44 de sélection de cellule est apte à mettre en œuvre les étapes E6 à E8.

Dans le mode de réalisation particulier qui vient d'être décrit, il est prévu une phase d'apprentissage (étape E00 à E011) permettant de déterminer les courbes d'évolution $C_1$ et $C_2$, puis, pour chaque cellule $CLC_k$, une étape E2 de détermination d'un niveau d'excitation ajusté $P[CLC_k]$ à la cellule considérée $CLC_k$.

Dans un autre mode de réalisation particulier, les cellules $CLC_k$ sont excitées à un niveau d'excitation prédéfini, non adaptatif, qui peut être le même pour toutes les cellules. Le niveau d'excitation d'une cellule à contrôler $CLC_k$ n'est dans ce cas pas ajusté à la cellule considérée. Un niveau d'excitation typique est de l'ordre de 1 soleil. Ce niveau d'excitation peut toutefois être plus bas ou plus élevée, notamment compris entre 0.1 et 10 soleils. Dans ce cas, le procédé de contrôle de qualité des cellules $CLC_k$ est analogue à celui qui vient d'être décrit, à la différence près qu'il ne comprend pas ni phase d'apprentissage (étapes E00 à E011), ni étape (E2) de détermination d'un niveau d'excitation ajusté à chaque cellule. Le procédé selon cet autre mode de réalisation qui correspond au procédé revendiqué comprend, pour chaque cellule :

- une étape d'excitation E3, lors de laquelle la cellule à contrôler $CLC_k$ est soumise à une excitation à un niveau d'excitation prédéfini (non spécifiquement ajusté à la cellule) ;
- une étape E4 d'acquisition d'au moins une image $IM_{PL,k}$ de luminescence de la cellule à contrôler $CLC_k$ après excitation ;
- une étape E5 de traitement de l'image acquise $IM_{PL,k}$.

Lors de l'étape de traitement E5, l'image de luminescence de chaque cellule à contrôler CLCk est décomposée en une première image correspondant à la cellule sans défauts et une deuxième image correspondant à des défauts de ladite cellule (étape E50). Une image de luminescence de cellule étant composée d'un ensemble de pixels auxquels des valeurs respectives d'intensité de luminescence sont attribuées, pour décomposer l'image $IM_{PL,k}$ :

- on choisit une pluralité N de pixels de ladite image de luminescence $IM_{PL,k}$ ;
- on attribue à chacun des pixels choisis une valeur qui est représentative d'un environnement local dudit pixel ;
- on attribue une nouvelle valeur à chaque pixel de l'image à partir des valeurs des pixels choisis afin d'obtenir la première image $IM0_{PL,k}$ ;
- on détermine la deuxième image $IMd_{PL,k}$, en réalisant un ratio entre l'image de luminescence de la cellule $IM_{PL,k}$ et la première image $IM0_{PL,k}$.

Les pixels choisis de l'image de luminescence peuvent être situés à des emplacements périodiquement espacés. L'environnement local d'un pixel choisi est une zone contenant le pixel choisi, par exemple un carré centré sur celui-ci. La nouvelle valeur attribuée à chaque pixel de l'image est par exemple obtenue par interpolation des valeurs des pixels choisis.

On calcule ensuite (étape E51) une moyenne des valeurs d'intensité de luminescence associées aux pixels de la deuxième image afin de déterminer un paramètre de quantification des défauts de la cellule, comme précédemment explicité.

Pour la mise en œuvre de cet autre mode de réalisation, le système de contrôle est analogue à celui précédemment décrit, à la différence près que le dispositif de contrôle 4 ne comprend pas ni module d'apprentissage 40, ni module 41 de détermination d'un niveau d'excitation ajusté. Ainsi le système comprend un dispositif d'excitation adapté pour appliquer une excitation à une cellule à contrôler, un dispositif d'acquisition d'une image de luminescence de la cellule après excitation et un dispositif de contrôle comportant un module de traitement d'image 42, un module 43 d'évaluation d'un paramètre de perte de facteur de forme et un module 44 de sélection de cellule. Le module 42 de traitement d'image est adapté pour décomposer l'image de luminescence de chaque cellule à contrôler en une première image correspondant à la cellule sans défauts et une deuxième image correspondant à des défauts de la cellule, notamment pour choisir une pluralité N de pixels de ladite image de luminescence, attribuer à chacun des pixels choisis une valeur qui est représentative d'un environnement local dudit pixel, attribuer une nouvelle valeur à chaque pixel de l'image à partir des valeurs des pixels choisis afin d'obtenir la première image, déterminer la deuxième image à partir de l'image de luminescence et de la première image. En outre, le module de traitement d'image peut être adapté pour calculer une moyenne des valeurs d'intensité de luminescence associées aux pixels de la deuxième image afin de déterminer un paramètre de quantification des défauts de la cellule.

**Revendications**

1. Procédé de contrôle de qualité d'une pluralité de cellules photovoltaïques ($CLC_k$) comprenant, pour chaque cellule :

• une étape d'excitation (E3), lors de laquelle la cellule à contrôler (CLC$_k$) est soumise à une excitation ;
• une étape (E4) d'acquisition d'au moins une image (IM$_{PL,k}$) de luminescence de la cellule à contrôler (CLC$_k$) après excitation ;
• une étape (E5) de traitement de l'image acquise (IM$_{PL,k}$) ;

**caractérisé en ce que**, pour chaque cellule à contrôler, lors de l'étape de traitement, on décompose (E50) l'image de luminescence de la cellule à contrôler (CLC$_k$) en une première image correspondant à ladite cellule sans défauts et une deuxième image correspondant à des défauts de ladite cellule et **en ce que**, pour décomposer l'image de luminescence de la cellule à contrôler (CLC$_k$), l'image de luminescence de ladite cellule étant composée d'un ensemble de pixels auxquels des valeurs respectives d'intensité de luminescence sont attribuées :

• on choisit une pluralité (N) de pixels de ladite image de luminescence :
• on attribue à chacun des pixels choisis une valeur qui est représentative d'un environnement local dudit pixel ;
• on attribue une nouvelle valeur à chaque pixel de l'image à partir des valeurs des pixels choisis afin d'obtenir une première image correspondant à la cellule sans défauts :
• on détermine la deuxième image correspondant à des défauts de ladite cellule à partir de l'image de luminescence et de la première image en réalisant un ratio entre l'image de luminescence de la cellule et la première image.

**2.** Procédé selon la revendication précédente, **caractérisé en ce qu'**on calcule (E51) une moyenne des valeurs d'intensité de luminescence associées aux pixels de la deuxième image afin de déterminer un paramètre de quantification des défauts de la cellule.

**3.** Procédé selon la revendication précédente, **caractérisé en ce que** le paramètre de quantification des défauts est corrigé (E53) par un facteur de correction déterminé à partir d'une moyenne de valeurs des pixels de la première image.

**4.** Procédé selon l'une des revendications 1 à 3, **caractérisé en ce qu'**on attribue une nouvelle valeur à chaque pixel de l'image par interpolation des valeurs des pixels choisis.

**5.** Procédé selon l'une des revendications 1 à 4, **caractérisé en ce que** les pixels choisis de l'image de luminescence sont situés à des emplacements périodiquement espacés.

**Patentansprüche**

**1.** Verfahren zur Kontrolle der Qualität einer Mehrzahl von Photovoltaikzellen (CLC$_k$), umfassend, für jede Zelle:

• einen Schritt des Anregens (E3), bei dem die zu kontrollierende Zelle (CLC$_k$) einer Anregung unterzogen wird;
• einen Schritt (E4) des Erfassens mindestens eines Lumineszenzbildes (IM$_{PL,k}$) der zu kontrollierende Zelle (CLC$_k$) nach Anregung;
• einen Schritt (E5) des Verarbeitens des erfassten Bildes (IM$_{PL,k}$) ;

**dadurch gekennzeichnet, dass** bei dem Schritt des Verarbeitens für jede zu kontrollierende Zelle das Lumineszenzbild der zu kontrollierenden Zelle (CLC$_k$) in ein erstes Bild, das der fehlerfreien Zelle entspricht, und ein zweites Bild, das Fehlern der Zelle entspricht, zerlegt wird (E50) und dass zum Zerlegen des Lumineszenzbildes der zu kontrollierenden Zelle (CLC$_k$), das Lumineszenzbild der Zelle aus einer Anordnung von Pixeln besteht, denen jeweilige Lumineszenzintensitätswerte zugewiesen sind:

• eine Mehrzahl (N) von Pixeln des Lumineszenzbildes gewählt wird:
• jedem der gewählten Pixel ein Wert zugewiesen wird, der für eine lokale Umgebung des Pixels repräsentativ ist;
• jedem Pixel des Bildes ausgehend von den Werten der gewählten Pixel ein neuer Wert zugewiesen wird, um ein erstes Bild zu erhalten, das der fehlerfreien Zelle entspricht;
• das zweite Bild, das Fehlern der Zelle entspricht, ausgehend von dem Lumineszenzbild und dem ersten Bild bestimmt wird, indem ein Verhältnis zwischen dem Lumineszenzbild der Zelle und dem ersten Bild gebildet wird.

**2.** Verfahren nach dem vorhergehenden Anspruch, **dadurch gekennzeichnet, dass** ein Mittelwert der den Pixeln des zweiten Bildes zugewiesenen Lumineszenzintensitätswerte berechnet wird (E51), um einen Parameter zur Quantifizierung der Fehler der Zelle zu bestimmen.

**3.** Verfahren nach dem vorhergehenden Anspruch, **dadurch gekennzeichnet, dass** der Parameter zur Quantifizierung der Fehler durch einen Korrekturfaktor korrigiert wird (E53), der ausgehend von einem Mittelwert von Werten der Pixel des ersten Bildes bestimmt wird.

**4.** Verfahren nach einem der Ansprüche 1 bis 3, **dadurch gekennzeichnet, dass** jedem Pixel des Bildes durch Interpolation der Werte der gewählten Pixel ein neuer Wert zugewiesen wird.

**5.** Verfahren nach einem der Ansprüche 1 bis 4, **dadurch gekennzeichnet, dass** die gewählten Pixel des Lumineszenzbildes an periodisch beabstandeten Stellen gelegen sind.

**Claims**

**1.** Method for monitoring the quality of a plurality of photovoltaic cells ($CLC_k$), the method comprising, for each cell:

- an excitation step (E3), during which the cell to be monitored ($CLC_k$) is subjected to an excitation;
- a step (E4) of acquiring at least one luminescence image ($IM_{PL,k}$) of the cell to be monitored ($CLC_k$) after excitation;
- a step (E5) of processing the acquired image ($IM_{PL,\,k}$) ;

**characterized in that**, for each cell to be monitored, the processing step, comprises decomposing (E50) the luminescence image of the cell to be monitored ($CLC_k$) into a first image corresponding to the cell without defects and a second image corresponding to defects of the cell, and **in that**, to decompose the luminescence image of the cell to be monitored ($CLC_k$), the luminescence image of the cell being composed of a set of pixels to which respective luminescence intensity values are assigned:

- a plurality (N) of pixels from said luminescence image is selected;
- each of the selected pixels is assigned a value that is representative of a local environment of said pixel;
- a new value is assigned to each pixel of the image based on the values of the selected pixels in order to obtain a first image corresponding to the cell without defects;
- the second image corresponding to defects in said cell is determined from the luminescence image and the first image by forming a ratio between the luminescence image of the cell and the first image.

**2.** The method according to the previous claim, comprising calculating (E51) a mean of the luminescence intensity values associated with the pixels of the second image in order to determine a parameter for quantification of the defects of the cell.

**3.** The method according to the previous claim, **characterized in that** the defect quantification parameter is corrected (E53) by a correction factor determined from a mean of the pixel values of the first image.

**4.** The method according to claims 1 to 3, comprising assigning a new value to each pixel of the luminescence image by interpolation of the values of the selected pixels.

**5.** The method according to claims 1 to 4, wherein the selected pixels of the luminescence image are situated at periodically spaced-apart locations.

**Figure 1**

**Figure 2**

**Figure 3**

**Figure 4A**          **Figure 4B**          **Figure 4C**

FAB {CLA$_1$, CLA$_2$, ...,
CLA$_i$, ..., CLA$_N$}

E00

MES $V_{oc\_i}$ (i=1, ...,N)

E01

$\overline{V_{oc}}$

E02

EXCIT CLA$_i$ (i=1, ...,N)

E03

MES $I_{PL\_i}$

E04

i=i+1

N

i=N ?

E05

Y

$\left( V_{oc\_i}, I_{PL\_i} \right)_{1 \leq i \leq N}$ → C$_1$

E06

$I_{PL,ref}$

E07

E08

**Figure 5A**

E07

Pj [CLA$_1$]  E08

MES $I_{PL,1}[P_j]$  E09

N  j=M ?  E010

j=j+1

Y

$(P_j, I_{PL\_1}[P_j])_{1 \leq j \leq M} \rightarrow C_2$  E011

E012

$\Delta FF_i$  E0120

i=i+1

GL$_i$  E0121

N  i=N ?  E0122

Y

TSH$_{GL}$  E013

**Figure 5B**

Figure 6A

**E4**

$IM_{PL,k} \rightarrow IM0_{PL,k}, IMd_{PL,k}$ — **E50**

$$G_{d,k} = \frac{\sum_{i=1}^{n} Id_{PL,k,i}}{n}$$ — **E51**

$$G_{0,k} = \frac{\sum_{i=1}^{n} I0_{PL,k,i}}{n}$$ — **E52**

$$GL_k = \frac{G_{d,k}}{1 - G_{0,k}}$$ — **E53**

**E5**

**E6**

$GL_k \geq TSH_{GL}?$

**E8**

EXIT

**E7**

MTL

**Figure 6B**

**Figure 7**

**Figure 8**

## RÉFÉRENCES CITÉES DANS LA DESCRIPTION

**Documents brevets cités dans la description**

- US 20110025839 A1

**Littérature non-brevet citée dans la description**

- **AUGARTEN Y.** ; **TRUPKE T.** ; **LENIO M.** ; **BAUER J.** ; **WEBER J.W.** ; **JUHL M** ; **KASEMANN M.** ; **BREITENSTEIN O**. Calculation of quantitative shunt values using photoluminescence imaging. *Prog. Photovolt. : Res. Appli.*, 2013, vol. 21, 933-941
- **MCHL B.** ; **IMPERA D.** ; **BIVOUR M.** ; **WARTA W.** ; **SCHUBERT M.C**. Suns-PLI as a powerful tool for spatially resolved fill factor analysis of solar cells. *Prog. Photovolt. : Res. Appl.*, 2012
- **JOHNSTON S. et al.** Correlations of Cu(In, Ga)Se2 imaging with device performance, defects and microstructural properties. *J. Vac. Sci. Technol. A*, 2012, vol. 30, 04D111

- **RONNY BAKOWSKIC et al.** Comparison of recombination active defects in multicrystalline silicon by means of photoluminescence imaging and reverse biased electroluminescence. *26th European Photovoltaic Solar Energy Conference and Exhibition*, 2011, 1839
- A Fill Factor Loss Analysis Method for Silicon Wafer Solar Cells. *IEEE Journal of photovoltaics*, October 2013, vol. 3 (4)